# EUROPÄISCHE PATENTSCHRIFT

(11) **EP 0 701 141 B1**
(45) Veröffentlichungstag und Bekanntmachung des Hinweises auf die Patenterteilung: **13.11.2002**
(21) Anmeldenummer: 95112918.8
(22) Anmeldetag: 17.08.1995
(51) Int. Cl.: G01R 33/07

(54) **Magnetfeldsensor mit Hallelement**
Magnetic field sensor with Hall element
Capteur de champs magnétique muni d'un élément de Hall

(30) Priorität: 06.09.1994 DE 4431703
(43) Veröffentlichungstag der Anmeldung: 13.03.1996
(73) Patentinhaber: Micronas GmbH, 79108 Freiburg (DE)
(72) Erfinder: Theus, Ulrich, Dr. Ing., D-79194 Gundelfingen (DE); Motz, Mario, Dipl. Ing., D-79346 Endingen (DE)

(56) Entgegenhaltungen:
- EP-A- 0 450 910
- EP-A- 0 460 564
- EP-A- 0 548 391
- DE-A- 4 302 342

## Beschreibung

Die Erfindung betrifft einen Magnetfeldsensor mit einem Hallelement, mit einer Spannungsversorgungseinrichtung und einer Auswerteeinrichtung, welcher ein Hallsignal des Hallelements zuführbar ist, wobei die Auswerteeinrichtung einen Eingangs-verstärker, ein Speicherelement und eine Signalüberlagerungseinheit umfaßt.

Ein solcher Magentfeldsensor ist aus der EP 0 548 391 A1 (ITT-Case, C-DIT-1445) bekannt. Er wird in der Praxis häufig als monolithisch integriertes Bauelement ausgeführt, welches das Hallelement, die Spannungsversorgungseinrichtung und die Auswerteeinrichtung umfaßt. Die Herstellung einer solchen kombinierten Schaltung erfolgt in der Regel über eine der üblichen Silizium-Halbleitertechnologien, wie Bipolaroder MOS-Herstellungsverfahren. Die Genauigkeit eines solchen Magnetfeldsensors wird dadurch erhöht, daß die Offsetsignalkomponente des Hallelements durch die Überlagerung eines ersten und eines zweiten Meßsignales kompensiert wird. Diese Offsetsignalkomponente des Hallelements wird durch mechanische Spannungen in dem Umfeld des Hallelements, also in dem Kristallgefüge des monolithischen Bauelements erzeugt. Die Kompensation kommt dadurch zustande, daß die Anschlußpaare des Hallelements, die mit der Spannungsversorgungseinrichtung und der Auswerteeinrichtung verbunden sind, bei der Bestimmung des ersten Meßsignals hinsichtlich der Bestimmung des zweiten Meßsignals miteinander vertauscht sind. Durch das Vertauschen der Anschlußpaare wird ein im folgendem "Anschlußpaarumschalten" genanntes Umschalten der Spannungsquellen - und Auswerteanschlüsse des Hallelements erreicht. Aufgrund der Geometrie des Hallelements und der Anschlußpaare sind die resultierenden Nutzsignalkomponenten der Meßsignale vor und nach der Anschlußpaarumschaltung gleichphasig, wohingegen die resultierenden Offsetsignalkomponenten des Hallelements gegenphasig sind. Durch Addition der vor und nach dem Umschalten erzeugten Meßsignale in der Auswerteeinrichtung wird die Offsetsignalkomponente des Hallelements eliminiert. Die Modelldarstellung für diesen Effekt erfolgt, indem eine Hallplatte in erster Näherung als eine Widerstandsbrückenschaltung aufgefaßt wird, die auf Null abgeglichen ist, wenn kein Magnetfeld vorhanden ist. Die Offsetsignalkomponente wird durch im Kristall aufgrund von Piezo-Effekten auftretenden Widerstandsänderungen sowie durch Lithographieungenauigkeiten, etc. erzeugt.

Nachteilig an diesem Magnetfeldsensor ist, daß seine Genauigkeit durch die Offsetsignalkomponenten der elektronischen nachfolgenden Bauelemente in der Auswerteeinrichtung beeinträchtigt wird. So wird etwa durch die Summenbildung des ersten Signales und des zweiten Signales, welche zur Kompensation der Offsetsignalkomponente des Hallelements erforderlich ist, die Offsetsignalkomponente des Eingangsverstärkers addiert.

Der Erfindung liegt die Aufgabe zugrunde, einen Magnetfeldsensor zu schaffen, der eine größere Genauigkeit aufweist.

Diese Aufgabe wird durch einen gattungsgemäßen Magnetfeldsensor gelöst, bei dem mit der Auswerteeinrichtung in einer ersten Phase aus einem ersten Hallsignal ein Abgleichsignal zum Durchführen eines Meßsignalabgleichs des Signalpfades bezüglich einer Schnittstelle zwischen dem Eingangsverstärker und der Signalüberlagerungseinheit erzeugbar ist, wobei das Abgleichsignal in dem Speicherelement speicherbar ist, und in einer zweiten Phase über die Signalüberlagerungseinheit das in dem Speicherelement gespeicherte Abgleichsignal der Schnittstelle zuführbar ist und dort einem Hallsignal (zweites Hallsignal) überlagerbar ist.

Aufgrund der erfindungsgemäßen Anordnung wird erreicht, daß die Offsetsignalkomponenten der Auswerteeinrichtung, insbesondere des Eingangsverstärkers und der Überlagerungseinheit zusätzlich eliminiert werden. Es wird sozusagen in der ersten Phase ein Offsetabgleich der Auswerteeinrichtung durchgeführt. Hierdurch wird die Meßgenauigkeit des Magnetfeldsensors verbessert.

Gemäß einer vorteilhaften Weiterbildung der Erfindung ist in der ersten Phase der Schnittstelle ein erstes Hallsignal zuführbar, und das zweite Hallsignal ist durch Invertierung des ersten Hallsignal erzeugbar. Durch diese Maßnahme verdoppelt sich die Nutzsignalkomponente des Meßsignals, während die Offsetsignalkomponente der Auswerteeinrichtung kompensiert wird. Günstigerweise kann die Invertierung des Hallsignals mittels einer Anschlußpaarumschaltung des Hallelements bewirkt werden. Dabei ist das Hallelement hinsichtlich seines Widerstands zu zwei zueinander orthogonalen Achsen symmetrisch und weist zwei entsprechend symmetrische Anschlußpaare auf, die während der ersten und der zweiten Phase alternierend über eine Schaltvorrichtung mit der Spannungsversorgungseinrichtung und der Auswerteeinrichtung verbindbar sind, wobei gegebenenfalls die Hallspannungsabgriffe bezüglich der Polarität umgepolt werden müssen. So kann gleichzeitig mit den Offsetkomponenten der Auswerteeinrichtung, insbesondere des Eingangsverstärkers und der Überlagerungseinheit, die Offsetkomponente des Hallelements selbst eliminiert werden.

Gemäß einer vorteilhaften Weiterbildung der Erfindung umfaßt das Speicherelement mindestens einen Kondensator. Mit diesem kann das erste Signal auf einfache Weise gespeichert werden. Auch ist es vorteilhaft, wenn die Auswerteeinrichtung einen Komparator als Ausgang umfaßt. Mit diesem kann das Ausgangssignal auf einfache Weise mit einem Vergleichssignal verglichen werden. So kann z.B. sicher festgestellt werden, ob die so eingestellten magnetischen Umschaltpunkte überschritten wurden. Der Vergleichswert kann ein unipolares Signal sein; vorteilhafterweise kann er auch ein Differenzsignal sein, das dem Komparator durch eine symmetrische Anordnung in der Auswerteeinrichtung gegenphasig zugeführt wird. Derartig betriebene symmetrische Anordnungen werden insbesondere dort verwendet, wo größere externe Störungen bei der Auswertung zu vermeiden sind. Die Auswerteeinrichtung kann ferner auch so ausgebildet sein, daß sie das Meßergebnis als analoges Meßsignal oder digitalisiert als Datenwort abgibt.

Gemäß einem vorteilhaften Ausführungsbeispiel der Erfindung kann der Eingangsverstärker einen ersten Transkonduktanzverstärker und die Überlagerungseinheit ein zweiten Transkonduktanzverstärker aufweisen, welche derart angeordnet sind, daß ihre Ausgangsströme zur Differenzbildung auf einen gemeinsamen Verbindungspunkt geführt sind und der Kondensator mit einem Eingang der Überlagerungseinheit verbunden ist. Diese Anordnung wandelt die in der ersten und zweiten Phase an dem Hallelement abgegriffenen Meßsignale, welche die Hallspannung und die Offsetspannung des Hallelements beinhalten, mittels des Transkonduktanzverstärkers in ein erstes und in ein zweites Stromsignal um. Aufgrund des ersten Stromsignals wird in dem Speicherelement eine Spannung gespeichert und von dem zweiten Transkonduktanzverstärker wieder in ein Stromsignal verwandelt. Da der zweite Transkonduktanzverstärker einen zu dem Strom des ersten Transkonduktanzverstärkers entgegengerichteten Strom erzeugt, werden in der zweiten Phase das erste Stromsignal und das zweite Stromsignal in dem gemeinsamen Verbindungspunkt derart überlagert, daß sich die Nutzsignalkomponenten des Hallelements addieren und die Offsetkomponenten des Hallelements und insbesondere des ersten Transkonduktanzverstärkers kompensieren. Es entsteht somit ein Stromsignal, welches dem doppelten Wert der Nutzsignalkomponente des Hallelements entspricht und frei von den Offsetsignalkomponenten ist.

Vorteilhafterweise ist zwischen einem Ausgang des Eingangsverstärkers und einem Eingang der Überlagerungseinheit ein Schaltelement vorgesehen, welches während einer dritten Phase geschlossen ist, die innerhalb der ersten Phase beendet wird, und während der zweiten Phase geöffnet ist. Das Schaltelement kann von einer Schaltvorrichtung geschaltet werden, so daß es in der ersten Phase für eine Speicherung des ersten Meßsignales in dem Speicherelement sorgt und in der zweiten Phase zu der Überlagerung des ersten Meßsignales und des zweiten Meßsignales führt. Um störende Übergangseffekte zu vermeiden, sollte das Schaltelement während der ersten Phase öffnen und schließen.

Günstigerweise kann der zweite Transkonduktanzverstärker eine kleinere Steilheit aufweisen als der erste Transkonduktanzverstärker. Zur Erzeugung des gleichen Ausgangsstromes ist dann am Eingang des zweiten Transkonduktanzverstärkers eine größere Spannung erforderlich, die im Kondensator gespeichert wird. Dadurch wird bewirkt, daß ein von dem zweiten Transkonduktanzverstärker erzeugtes Stromsignal eine entsprechend verkleinerte Störsignalempfindlichkeit aufweist. Hierdurch wird eine Verfälschung der Nutzsignalkomponente zum Bestimmen des Magnetfeldes aufgrund von Störsignalen am zweiten Transkonduktanzverstärker bzw. an der Überlagerungseinheit reduziert, wodurch die Genauigkeit des Magentfeldsensors weiter erhöht wird. Beispielsweise kann die Steilheit des zweiten Transkonduktanzverstärkers um einen Faktor 50 geringer sein als die des ersten Transkonduktanzverstärkers, so daß Störsignalkomponenten am zweiten Transkonduktanzverstärker um einen Faktor 50 verkleinert in das Gesamtsignal eingehen und somit die Genauigkeit des Magentfeldsensors nicht mehr beeinträchtigen.

Wesentlich für die Verringerung des Einflusses von derartigen Störsignalen ist, daß das erste Meßsignal verstärkt wird, von dem Speicherelement vergrößert gespeichert wird und von der Überlagerungseinheit wieder entsprechend reduziert herausgegeben wird. Somit wird eine Beeinträchtigung der Genauigkeit des Magentfeldsensors aufgrund des Speicherelements und der Überlagerungseinheit auch in anderen Ausführungsarten des erfindungsgemäßen Magentfeldsensors verhindert, bei denen in dem Eingangsverstärker und der Überlagerungseinheit keine Transkonduktanzverstärker verwendet werden.

Gemäß einer vorteilhaften Weiterbildung der Erfindung ist der Ausgang der Auswerteeinrichtung mit einer Halteschaltung zum Speichern und Weitergeben eines Ausgangssignals während der zweiten Phase verbunden. Die Halteschaltung ist typischerweise eine Latch- Schaltung. Die Übernahme des Auswertesignals in die Latch-Schaltung erfolgt erst, nachdem der eingeschwungene Zustand in der zweiten Phase erreicht wurde. Dadurch wird verhindert, daß kurzzeitige und nicht relevante Zustandsänderungen das Ausgangssignal beeinträchtigen, welche somit nicht fälschlicherweise als Signaländerung gewertet werden.

Gemäß einer günstiger: Weiterbildung der Erfindung ist ein zweites, lateral versetztes, identisches und bezüglich der Hallspannung antiparallel zu dem ersten geschaltetes Hallelement vorgesehen. Hierdurch wird erreicht, daß das Ausgangssignal der beiden Hallelemente nur auf eine Magnetfelddifferenz reagiert. Somit wird das Meßergebnis nicht durch vorhandene, störende, an beiden Hallelementen auftretende Magnetfelder beeinträchtigt. Der Magnetfeldsensor kann somit auch in einem Umfeld verwendet werden, in welchem sich äußere, dynamische oder stetig vorhandene, relativ großräumige magnetische Felder nicht vermeiden lassen. Ferner ist es vorteilhaft, wenn eine Stromquelle zum Erzeugen eines Vorspannungssignals an dem jeweils mit der Auswerteeinrichtung verbundenen Anschlußpaar vorgesehen ist. Hierdurch wird erreicht, daß das nachzuweisende Magnetfeld einen bestimmten Schwellenwert überschreiten muß, um von dem Magnetfeldsensor nachgewiesen zu werden. Es ist günstig, wenn ein mit der Halteschaltung verbundenes Schaltmittel vorgesehen ist, über welches das jeweilige Vorspannungssignal von der Stromquelle an das jeweilige Anschlußpaar aufgrund eines Signals der Halteschaltung angelegt wird, wenn letztere das Ausgangssignal weitergegeben hat. Dadurch wird erreicht, daß die Vorspannung an dem jeweiligen Anschlußpaar dann angelegt ist, wenn ein Ausgangssignal von der Auswerteeinrichtung registriert worden ist. Das Magnetfeld muß sich daher erst um einen bestimmten Wert ändern, damit der Magnetfeldsensor auf diese Magnetfeldänderung anspricht. Somit erhält man eine Hysteresekurve, durch welche vermieden wird, daß der Zustand des Magnetfeldsensors ständig umkippt, und es wird ein stabiler Signalzustand erzeugt.

Gemäß einer vorteilhaften Weiterbildung der Erfindung kann ein Korrektursignalausgang der Stromquelle zur Ausgabe eines von der Temperatur des Hallelements abhängigen Signals mit einem Steuereingang der Spannungsversorgungseinrichtung verbunden sein. Mit dieser Anordnung können Meßfehler aufgrund der Temperaturabhängigkeit der Hallelementempfindlichkeit vermieden werden. Das den Hallelementen von der Spannungsversorgungseinrichtung zugeführte Signal muß von der Stromquelle derart geändert werden, daß es den Temperaturgang der Hallelementempfindlichkeit ausgleicht. Vorteilhafterweise kann in der Stromquelle ein dem Hallelement äquivalenter Referenzwiderstand vorgesehen sein. Wenn es sich um ein monolithisches Bauelement handelt, erfährt der dem Hallelement äquivalente Referenzwiderstand die gleichen Änderungen aufgrund von Temperatur- und Technologieschwankungen wie das Hallelement. Aufgrund der Änderungen des Referenzwiderstandes kann somit das Korrektursignal der Stromquelle geändert werden, da dieses dem Steuereingang der Spannungsversorgungseinrichtung zugeführt wird, kann das dem jeweiligen Anschlußpaar des Hallelements zugeführte Signal entsprechend geändert werden. Dadurch lassen sich Meßfehler des Magnetfeldsensors aufgrund von Temperatur- und Technologieschwankungen sehr zuverlässig korrigieren.

Im folgenden wird die Erfindung anhand der Figuren näher beschrieben.

Es zeigen:
Fig. 1 eine schematische Darstellung eines Ausführungsbeispiels der Erfindung und
Fig. 2 den Verlauf von Taktsignalen für (a) die erste Phase, (b) die zweite Phase, (c) zum Speichern des ersten Signales in dem Speicherelement und (d) zum Anlegen eines Vorspannungssignals an ein Anschlußpaar eines Hallelements.

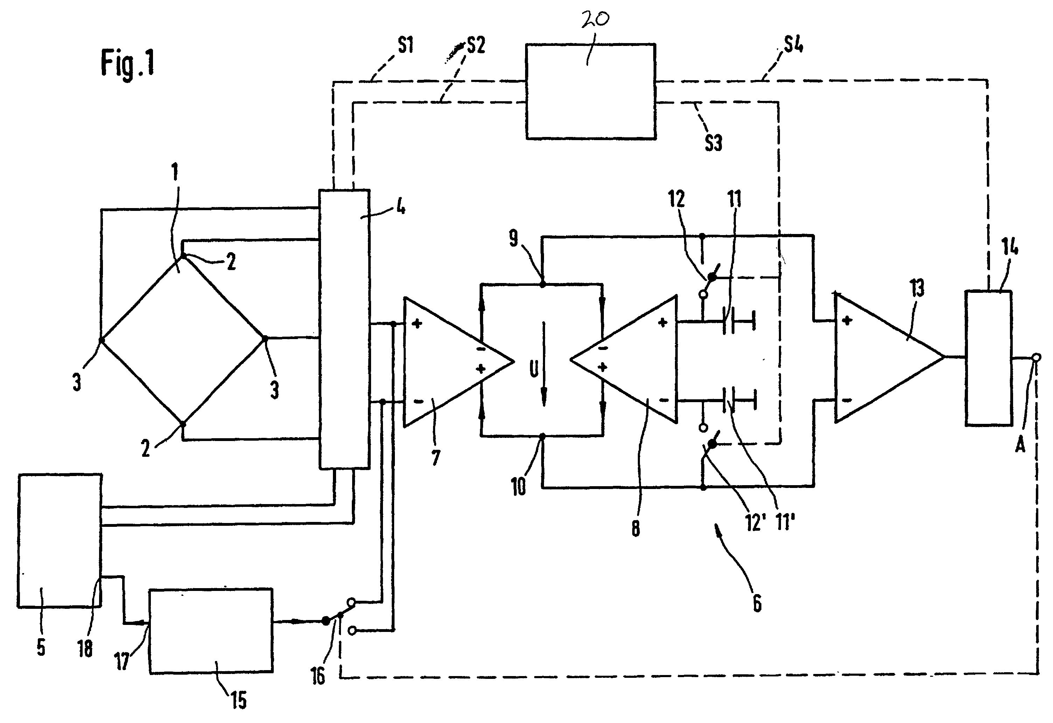

Fig. 1 zeigt das Blockschaltbild eines Ausführungsbeispiels des erfindungsgemäßen Magentfeldsensors. Der Magnetfeldsensor weist ein Hallelement 1 mit zwei Anschlußpaaren 2, 3 auf. Die Anschlußpaare 2, 3 sind mit einer Schaltvorrichtung 4 derart verbunden, daß sie mit einer Spannungsversorgungseinrichtung 5 und einer Auswerteeinrichtung 6 alternierend verbunden werden können. Dabei ist die Spannungsversorgungseinrichtung 5 hier eine Spannungsquelle. Die Auswerteschaltung 6 umfaßt einen ersten Transkonduktanzverstärker 7 und einen zweiten Transkonduktanzverstärker 8. Die Transkonduktanzverstärker 7 und 8 sind derart angeordnet, daß ihre Ausgangsströme zur Differenzbildung auf gemeinsame Verbindungspunkte 9 bzw. 10 geführt werden. Die Transkonduktanzverstärker weisen beide zueinander komplementäre Ein- und Ausgänge auf. Diese Anordnung wird hier gewählt, um eine symmetrische Anordnung der Auswerteeinrichtung 6 zu erhalten, welche in Gegenphase bzw. im Differenzbetrieb betrieben wird. Diese Symmetrie dient dazu, Störungen die etwa aufgrund von außen vorhandenen Signalen auftreten können, zu eliminieren. Mit jedem Eingang des zweiten Transkonduktanzverstärkers 8 ist ein Kondensator 11, 11' verbunden. Zwischen den Ausgängen des ersten Transkonduktanzverstärkers 7 und dem jeweils auf der gleichen Symmetrieseite der Auswerteeinrichtung 6 liegenden Eingang des zweiten Transkonduktanzverstärkers 8 ist jeweils ein Schaltelement 12,12' vorgesehen. Die Schaltelemente 12,12' können von einer Schaltvorrichtung 20 geschaltet werden. Der Ausgang der Auswerteeinrichtung 6 wird durch ein Komparator 13 gebildet, in welchem die gemessene Spannung U zwischen den Verbindungspunkten 9 und 10 ausgewertet wird. Der Ausgang des Komparators 13 ist mit einer Halteschaltung 14 verbunden, welche einer Latch-Schaltung entspricht. Eine Stromquelle 15 zum Erzeugen eines Vorspannungssignals ist mit den an der Auswerteeinrichtung 6 angeschlossenen Anschlußpaaren 2 oder 3 verbunden. Ferner ist ein mit der Halteschaltung 14 verbundenes Schaltmittel 16 vorgesehen. Aufgrund eines Signals der Halteschaltung 14 wird über das Schaltmittel 16 ein von der Stromquelle 15 kommendes Vorspannungssignal an das entsprechende Anschlußpaar 2 oder 3 angelegt. Ein Korrektursignalausgang 17 der Stromquelle 15 ist mit einem Steuereinang 18 mit der Spannungsquelle 5 verbunden.

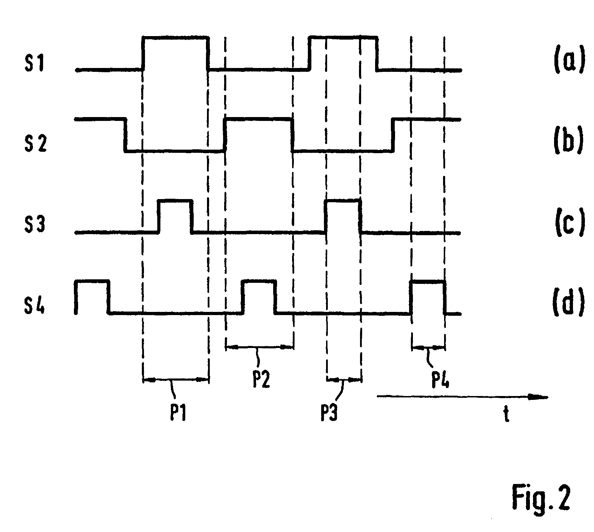

Im folgenden wird die Funktionsweise des erfindungsgemäßen Magnetfeldsensors erläutert. Über die Schalteinheit 4 werden die Anschlußpaare 2, 3 des Hallelements 1 während einer ersten und einer zweiten Phase P1, P2 alternierend mit der Spannungsquelle 5 und der Auswerteeinrichtung 6 verbunden. Während der ersten Phase P1 ist z.B. das Anschlußpaar 2 mit der Spannungsquelle 5 und das Anschlußpaar 3 mit der Auswerteeinrichtung 6 verbunden. In der zweiten Phase P2 wird dann mit der Schaltvorrichtung 4 das Anschlußpaar 3 des Hallelementes 1 mit der Spannungsquelle 5 und das Anschlußpaar 1 mit der Auswerteeinrichtung 6 verbunden. Das Taktsignal S1 zum Umschalten in die erste Phase P1 ist in Fig. 2a und das Taktsignal S2 zum Umschalten in die zweite Phase P2 in Fig. 2b gezeigt. In der ersten Phase P1 sind die Schaltelemente 12, 12' geschlossen. Das die Schaltelemente 12, 12' schließende Taktsignal S3 ist in Fig. 2c dargestellt. Das in der ersten Phase P1 zu der Auswerteeinrichtung 6 gelangende erste Meßsignal enthält eine erste Nutzsignalkomponente und eine erste Offsetsignalkomponente des Hallelements 1. Dieses Meßsignal wird in dem ersten Transkonduktanzverstärker 7 in ein entsprechendes Stromsignal verwandelt. Dabei erzeugen die beiden verschiedenen Eingänge des ersten Transkonduktanzverstärkers 7 zueinander invertierte Signale gleicher Größe. Diese ersten Meßsignale laden über die geschlossenen Schalter 12, 12' die Kondensatoren 11, 11' während einer Phase P3 auf. Das hierfür erforderliche Taktsignal S3 ist in Fig. 2(c) dargestellt. Es ist so gewählt, daß die Aufladezeit der Kondensatoren 11, 11' innerhalb der zweiten Phase P2 liegt, so daß ein stabiler Zustand der zweiten Phase gewährleistet ist. Der zweite Transkonduktanzverstärker 8 erzeugt einen dem Strom des ersten Transkonduktanzverstärkers 7 entgegengerichteten Strom. Diese beiden zueinander entgegengerichteten Ströme überlagern sich jeweils in den Verbindungspunkten 9 und 10 zu einem Gesamtstrom der Größe Null, da sie gleich groß sind. Bezüglich dem resultierenden Differenzstrom in den Verbindungspunkten kann der Meßsignalabgleich auch als Nullabgleich bezeichnet werden, denn der automatische Abgleich wertet als Regelgröße die Größe und Richtung des Differenzstromes aus und ändert solange die Kondensatorspannung 11, 11', bis der Differenzstrom zu Null wird.

In der zweiten Phase P2 gelangt ein zweites Meßsignal über die Schaltvorrichtung 4 an die Auswerteeinrichtung 6. Da die Anschlußpaare 2, des Hallelements 1 in dieser Phase P2 gegenüber der ersten Phase P1 vertauscht sind, enthält das zweite Meßsignal eine zweite, gleich große Nutzspannungskomponente, welche eine zu der ersten Nutzspannungskomponente entgegengesetzte Phase aufweist, und eine zweite Offsetsignalkomponente des Hallelements, welche die gleiche Phase und den gleichen Betrag wie die erste Offsetsignalkomponente des Hallelements aufweist. Bei Durchlaufen des ersten Transkonduktanzverstärkers 7 überlagert sich dem zweiten Meßsignal eine zweite Offsetsignalkomponente des Transkonduktanzverstärkers 7 und Überlagerungseinheit 8, welche in gleicher Phase zu der ersten Offsetsignalkomponente des ersten Transkonduktanzverstärkers 7 und der Überlagerungseinheit 8 ist, die dem ersten Meßsignal überlagert worden ist. Da die Schaltelemente 12, 12'während der zweiten Phase P2 offen sind (Fig. 2c), liegen am zweiten Transkonduktanzverstärker 8 noch die in den Kondensatoren 11,11'gespeicherten Spannungen des ersten Meßsignales an. Somit werden die von dem zweiten Transkonduktanzverstärker 8 auf die Verbindungspunkte 9, 10 zulaufenden Ströme von dem ersten Meßsignal bestimmt, wohingegen die von dem ersten Transkonduktanzverstärker 7 erzeugten Ströme von dem zweiten Meßsignal bestimmt werden. Da die Differenzspannung U zwischen den Verbindungspunkten 9, 10 die Nutzsignalkomponenten in der ersten und zweiten Phase P1, P2 als gleichphasige Komponente, die Offsetsignalkomponenten des Hallelements sowie die Offset-signalkomponenten des Eingangsverstärkers und der Überlagerungseinheit als gegenphasige Komponenten enthält, mitteln sich die Offsetsignalkomponenten in dem Gesamtsignal U heraus, wohingegen sich die Nutzsignalkomponenten der Phasen P1 und P2 addieren. Die in dem Komparator 13 nachgewiesene Spannung entspricht somit der zweifachen Nutzsignalkomponente. Voraussetzung für das Meßverfahren ist, daß das zweite Meßsignal bei unverändertem Magnetfeld gemessen wird, sodaß die Nutzsignalkomponenten gleich groß sind.

Der hier beschriebene symmetrische Aufbau der Auswerteeinrichtung 6, bei welchem die beiden symmetrischen Zweige in Gegentakt durchlaufen werden, dient zum Beseitigen häufiger Störungen. Die erfindungsgemäße Schaltung kann auch nur mit jeweils einem Zweig betrieben werden, bei dem die Transkonduktanzverstärker 7, 8 jeweils einen Stromausgang aufweisen, nur ein Kondensator 11, ein Schalter 12 und ein Komparator 13 mit einem Referenzeingang verwendet werden.

Die Transkonduktanzverstärker 7, 8 werden so gewählt, daß der zweite Transkonduktanzverstärker 8 eine deutlich kleinere Steilheit aufweist als der erste Transkonduktanzverstärker 7. Dies kann durch ein entsprechendes W/L-Verhältnis der entspechenden Transistoren realisiert werden. Ein typisches Verhältnis für die Steilheit der Transkonduktanzverstärker 7 und 8 ist ein Faktor 50. In diesem Fall verringert sich die Störempfindlichkeit des Meßsignalabgleichs.

Wenn von dem Hallelement 1 ein Magnetfeld gemessen wird, ändert sich das zu dem Komparator 13 gelangende Signal, welches in der vierten Phase P4 übernommen wird (Fig. 2 (d)). Das Signal der zweiten Phase wird an die Halteschaltung 14, welche einer Latch-Schaltung entspricht, weitergegeben. Die Halteschaltung 14 speichert das Signal und gibt es an den Ausgang A weiter. Die Speicherung und Weitergabe des Signals erfolgt mit dem in Fig. 2 (d) dargestellten Taktsignal S4. Die Zeit, in welcher das Signal gespeichert wird und dabei einen bestimmten Wert aufweisen muß, liegt in dem mittleren Bereich der Phase 2. Dadurch wird sichergestellt, daß der Zustand der zweiten Phase bereits eingeschwungen ist und ein stabiler Zustand der Auswertephase erreicht ist. Hierdurch wird gewährleistet, daß ein tatsächliches Signal vorhanden ist, und es sich nicht nur um kurze zeitliche Schwankungen handelt.

Die Stromquelle 15 dient zur Erzeugung einer Hysterese. Sie erzeugt ein Vorspannungssignal, welches an das Anschlußpaar 2 oder 3 angelegt wird, welches zu dem entsprechenden Zeitpunkt mit der Auswerteeinrichtung 6 verbunden ist. Dieses Vorspannungssignal bewirkt, daß ein von dem Hallelement 1 wahrgenommenes Magnetfeld erst dann nachgewiesen wird, wenn dieses Magnetfeld einen vorgegebenen Schwellenwert überschreitet. Die Verbindung der Stromquelle 15 mit den Anschlußpaaren 2 oder 3 erfolgt über das Schaltmittel 16. Das Schaltmittel 16 wird mittels des von der Halteschaltung 14 ausgegebenen Signals geschaltet, wenn die Halteschaltung 14 das Ausgangssignal weitergegeben hat. Hierdurch wird bewirkt, daß sobald ein Ausgangssignal von der Halteschaltung 14 zuverlässig nachgewiesen wurde, das zu überwindende Schwellenmagnetfeld an dem Anschlußpaar einen anderen Wert annimmt. Somit wird verhindert, daß die Auswerteschaltung aufgrund von kleinen Magnetfeldschwankungen hin und her schaltet.

Zum Verhindern von Fehlern aufgrund der Temperatur- und Technologieabhängigkeit des Hallelements 1, welche dessen Hallspannung und damit den gemessenen Magnetfeldwert verfälschen würde, ist der Korrektursignalausgang 17 der Stromquelle 15 mit dem Steuereingang 18 der Spannungsversorgungseinrichtung 5 verbunden. In der Stromquelle 15 kann z.B. ein Referenzwiderstand aus dem gleichen Material wie das Hallelement 1 vorgesehen sein, welcher den gleichen Temperaturgang und Schichtwiderstand wie das Hallelement 1 aufweist. Aufgrund der Änderung des Referenwiderstandes wird das Signal des Korrekturausgangs geändert.

In der Fig. 1 ist der Magnetfeldsensor mit einem Hallelement 1 gezeigt. Es kann jedoch gemäß einem weiteren Ausführungsbeispiel der Erfindung ein zweites Hallelement zu dem ersten antiparallel geschaltet werden, welches räumlich lateral versetzt angeordnet ist. Das zweite Hallelement muß dann zu dem ersten Hallelement geometrisch bzw. hinsichtlich des Widerstandes gleich sein. Damit reagieren die beiden Hallelemente gleichermaßen auf magnetische Fernfelder, wie z.B. Störmagnetfelder durch Anlasser oder Lichtmaschine im Automobil so daß das Ansprechen auf solche Felder vermieden werden kann. Magnetischen Nahfelder, die z.B. durch Vorbeibewegen eines Magneten auftreten, werden dann aufgrund der Differenzanordnung der beiden Hallelemente ohne Überlagerung der Fernfeldkomponenten nachgewiesen. Dies kann sich sowohl auf magnetische Gleichfelder als auch auf magnetische Wechselfelder beziehen.

## Patentansprüche

1. Magnetfeldsensor mit einem Hallelement (1), mit einer Spannungsversorgungseinrichtung (5) und einer Auswerteeinrichtung (6), welcher ein Hallsignal des Hallelements (1) zuführbar ist, wobei die Auswerteeinrichtung (6) einen Eingangsverstärker (7), ein Speicherelement (11) und eine Signalüberlagerungseinheit (8) umfaßt,
**dadurch gekennzeichnet,**
**daß** mit der Auswerteeinrichtung (6) in einer ersten Phase aus einem ersten Hallsignal ein Abgleichsignal zum Durchführen eines Meßsignalabgleichs des Signalpfades bezüglich einer Schnittstelle (9, 10) zwischen dem Eingangsverstärker (7) und der Signalüberlagerungseinheit (8) erzeugbar ist, wobei das Abgleichsignal in dem Speicherelement (11) speicherbar ist, und daß in einer zweiten Phase über die Signalüberlagerungseinheit (8) das in dem Speicherelement (11) gespeicherte Abgleichsignal der Schnittstelle (9, 10) zuführbar ist und dort einem zweiten Hallsignal überlagerbar ist.

2. Magnetfeldsensor nach Anspruch 1, **dadurch gekennzeichnet, daß** in der ersten Phase das erste Hallsignal über die Schnittstelle (9, 10) der Auswerteeinrichtung zuführbar ist und das zweite Hallsignal durch Invertierung des ersten Hallsignals erzeugbar ist.

3. Magnetfeldsensor nach Anspruch 1 oder 2, **dadurch gekennzeichnet, daß** die Invertierung des Hallsignals mittels einer Anschlußpaarumschaltung des Hallelements (1) erzeugbar ist.

4. Magnetfeldsensor nach einem der vorangehenden Ansprüche, **dadurch gekennzeichnet, daß** das Speicherelement (11, 11') mindestens einen Kondensator umfaßt.

5. Magnetfeldsensor nach einem der vorangehenden Ansprüche, **dadurch gekennzeichnet, daß** die Auswerteeinrichtung (6) einen Komparator (13) als Ausgang umfaßt.

6. Magnetfeldsensor nach einem der vorangehenden Ansprüche, **dadurch gekennzeichnet, daß** der Eingangsverstärker (7) einen ersten Transkonduktanzverstärker und die Überlagerungseinheit (8) einen zweiten Transkonduktanzverstärker aufweist, welche derart angeordnet sind, daß ihre Ausgangsströme zur Differenzbildung auf einen als Schnittstelle wirkenden gemeinsamen Verbindungspunkt (9, 10) geführt sind, und der Kondensator (11, 11') mit einem Eingang der Überlagerungseinheit (8) verbunden ist.

7. Magnetfeldsensor nach Anspruch 6, **dadurch gekennzeichnet, daß** zwischen einem Ausgang des Eingangsverstärkers (7) und einem Eingang der Überlagerungseinheit (8) ein Schaltelement (12, 12') vorgesehen ist, welches während einer dritten Phase geschlossen ist, die innerhalb der ersten Phase (P1) begonnen und beendet wird, und während der zweiten Phase (P2) geöffnet ist.

8. Magnetfeldsensor nach Anspruch 6 oder 7, **dadurch gekennzeichnet, daß** der zweite Transkonduktanzverstärker (8) eine kleinere Steilheit aufweist als der erste Transkonduktanzverstärker (7).

9. Magnetfeldsensor nach einem der vorangehenden Ansprüche, **dadurch gekennzeichnet, daß** der Ausgang der Auswerteeinrichtung (6) mit einer Halteschaltung (14) zum Speichern und Weitergeben eines Ausgangssignals während der zweiten Phase (P2) verbunden ist.

10. Magnetfeldsensor nach einem der vorangehenden Ansprüche, **dadurch gekennzeichnet, daß** zusätzlich ein zweites, bezüglich der Hallspannung antiparallel zu dem ersten geschaltetes, lateral versetztes, identisches Hallelement vorgesehen ist.

11. Magnetfeldsensor nach einem der Ansprüche 3 bis 10, **dadurch gekennzeichnet, daß** eine Stromquelle (15) zum Erzeugen eines Vorspannungssignals an dem jeweils mit der Auswerteeinrichtung (6) verbundenen Anschlußpaar (2, 3) vorgesehen ist.

12. Magnetfeldsensor nach Anspruch 11, **dadurch gekennzeichnet, daß** ein mit der Halteschaltung (14) verbundenes Schaltmittel (16) vorgesehen ist, über welches das jeweilige Vorspannungssignal von der Stromquelle (15) an das jeweilige Anschlußpaar (2, 3) aufgrund eines Signales der Halteschaltung (14) angelegt wird, wenn letztere das Ausgangssignal weitergegeben hat.

13. Magnetfeldsensor nach Anspruch 11 oder 12, **dadurch gekennzeichnet, daß** ein Korrektursignalausgang (17) der Stromquelle (15) zur Ausgabe eines von der Temperatur des Hallelements (1) abhängigen Signals mit einem Steuereingang (18) der Spannungsversorgungseinrichtung (5) verbunden ist.

14. Magnetfeldsensor nach Anspruch 13, **dadurch gekennzeichnet, daß** in der Stromquelle (15) ein dem Hallelement (1) äquivalenter Referenzwiderstand vorgesehen ist.

15. Verfahren zum Betrieb eines Magnetfeldsensors gemäß einem der Ansprüche 1 bis 14, bei dem das erste Meßsignal während der ersten Phase gespeichert wird und während der zweiten Phase dem zweiten Meßsignal an der Schittstelle (9, 10) überlagert wird, wobei die Nutzsignalkomponenten gleichphasig und die Offsetsignalkomponenten des Hallelements und des Eingangsverstärkers gegenphasig überlagert werden.

16. Verfahren nach Anspruch 15, **dadurch gekennzeichnet, daß** das erste Meßsignal um einen bestimmten Faktor verstärkt gespeichert und dem zweiten Signal um den gleichen Faktor reduziert überlagert wird.

## Claims

1. A magnetic-field sensor comprising a Hall-effect device (1), a power supply (5), and an evaluating facility (6) which can be supplied with a Hall signal from the Hall-effect device (1) and which comprises an input amplifier (7), a storage element (11), and a signal superposition unit (8),
**characterized in**
**that** in a first phase, a balancing signal for balancing the measurement-signal path with respect to an interface (9, 10) between the input amplifier (7) and the signal superposition unit (8) is generable from a first Hall signal with the evaluating facility (6), the balancing signal being storable in the storage element (11), and that in a second phase, the balancing signal stored in the storage element (11) is feedable through the signal superposition unit (8) to the interface (9, 10), where it is superimposable on a second Hall signal.

2. A magnetic-field sensor as set forth in claim 1, **characterized in that** in the first phase, the first Hall signal is feedable through the interface (9, 10) to the evaluating facility, and that the second Hall signal is generable by inversion of the first Hall signal.

3. A magnetic-field sensor as set forth in claim 1 or 2, **characterized in that** the inversion of the Hall signal can be effected by a terminal-pair changeover of the Hall-effect device (1).

4. A magnetic-field sensor as set forth in any one of the preceding claims, **characterized in that** the storage element (11, 11') comprises at least one capacitor.

5. A magnetic-field sensor as set forth in any one of the preceding claims, **characterized in that** the evaluating facility (6) comprises a comparator (13) as an output element.

6. A magnetic-field sensor as claimed in any one of the preceding claims, **characterized in that** the input amplifier (7) and the superposition unit (8) comprise a first transconductance amplifier and a second transconductance amplifier, respectively, which are so arranged that their output currents are supplied to a common node (9, 10) acting as an interface for forming the difference therebetween, and that the capacitor (11, 11') is connected to one input of the superposition unit (8).

7. A magnetic-field sensor as set forth in claim 6, **characterized in that** between an output of the input amplifier (7) and an input of the superposition unit (8), a switching element (12, 12') is provided which is closed during a third phase and is open during the second phase (P2), the third phase being started and ended within the first phase (P1).

8. A magnetic-field sensor as set forth in claim 6 or 7, **characterized in that** the second transconductance amplifier (8) has a lower transconductance than the first transconductance amplifier (7).

9. A magnetic-field sensor as set forth in any one of the preceding claims, **characterized in that** the output of the evaluating facility (6) is coupled to a holding circuit (14) for holding and passing on an output signal during the second phase (P2).

10. A magnetic-field sensor as set forth in any one of the preceding claims, **characterized in that** there is provided a second Hall-effect device which is identical to and laterally displaced from the first Hall-effect device and is connected in parallel with, but in a direction opposite to, the first Hall-effect device with respect to the Hall voltage.

11. A magnetic-field sensor as set forth in any one of claims 3 to 10, **characterized in that** a current source (15) is provided for generating a bias signal to be applied between the respective terminal pair (2, 3) connected to the evaluating facility (6).

12. A magnetic-field sensor as set forth in claim 11, **characterized in that** a switching means (16) connected to the holding circuit (14) is provided via which the respective bias signal from the current source (15) is applied to the respective terminal pair (2, 3) in response to a signal from the holding circuit (14) when the latter has passed on the output signal.

13. A magnetic-field sensor as set forth in claim 11 or 12, **characterized in that** a correction-signal output (17) of the current source (15) for delivering a signal dependent on the temperature of the Hall-effect device (1) is connected to a control input (18) of the power supply (5).

14. A magnetic-field sensor as set forth in claim 13, **characterized in that** the current source (15) includes a reference resistance equivalent to the Hall-effect device (1).

15. A method of operating a magnetic-field sensor as set forth in any one of claims 1 to 14, comprising the steps of storing the first measurement signal during the first phase and superimposing the first measurement signal on the second measurement signal at the interface (9, 10) during the second phase, with the useful signal components being superposed in phase, and the offset-signal components of the Hall-effect device and the input amplifier being superposed in phase opposition.

16. A method as set forth in claim 15, **characterized in that** the first measurement signal is stored after being amplified by a given factor, and is superimposed on the second signal after being reduced by the same factor.

## Revendications

1. Capteur de champ magnétique comportant un élément à effet Hall (1), comprenant un dispositif d'alimentation en tension (5) et un dispositif d'évaluation (6), auquel on peut envoyer un signal de Hall de l'élément à effet Hall (1), le dispositif d'évaluation (6) comprenant un amplificateur d'entrée (7), un élément de mémoire (11) et une unité de superposition de signaux (8),
**caractérisé en ce que**
au moyen du dispositif d'évaluation (6), on peut produire, pendant une première phase (P1), à partir d'un premier signal de Hall, un signal d'égalisation pour la réalisation d'une égalisation du signal de mesure du trajet du signal concernant une interface (9, 10) qui est disposée entre l'amplificateur d'entrée (7) et l'unité de superposition de signaux (8), le signal d'égalisation pouvant être mémorisé dans l'élément de mémoire (11), **en ce que**, pendant une deuxième phase (P2), le signal d'égalisation mémorisé dans l'élément de mémoire (11) peut être envoyé à l'interface (9, 10) par l'intermédiaire de l'unité de superposition de signaux (8) et peut être superposé à un deuxième signal de Hall dans l'interface (9, 10).

2. Capteur de champ magnétique selon la revendication 1, **caractérisé en ce que**, pendant la première phase (P1), le premier signal de Hall peut être envoyé au dispositif d'évaluation (6) par l'intermédiaire de l'interface (9, 10) et **en ce que** le deuxième signal de Hall peut être produit par inversion du premier signal de Hall.

3. Capteur de champ magnétique selon la revendication 1 ou 2, **caractérisé en ce que** l'inversion du signal de Hall peut être produite au moyen d'une commutation des paires de contacts de l'élément à effet Hall (1).

4. Capteur de champ magnétique selon l'une quelconque des revendications précédentes, **caractérisé en ce que** l'élément de mémoire (11, 11') comprend au moins un condensateur

5. Capteur de champ magnétique selon l'une quelconque des revendications précédentes, **caractérisé en ce que** le dispositif d'évaluation (6) comprend un comparateur (13) en tant qu'étage de sortie.

6. Capteur de champ magnétique selon l'une quelconque des revendications précédentes, **caractérisé en ce que** l'amplificateur d'entrée (7) comporte un premier amplificateur à transconductance, **en ce que** l'unité de superposition de signaux (8) comporte un deuxième amplificateur à transconductance, les deux amplificateurs à transconductance étant disposés de telle manière que leurs courants de sortie sont envoyés, pour la formation de la différence, à un point de connexion (9, 10) commun qui agit en tant qu'interface et **en ce que** le condensateur (11, 11') est relié à une entrée de l'unité de superposition de signaux (8).

7. Capteur de champ magnétique selon la revendication 6, **caractérisé en ce que**, entre une entrée de l'amplificateur d'entrée (7) et une entrée de l'unité de superposition de signaux (8), on prévoit un élément de commutation (12, 12') qui est fermé pendant une troisième phase, qui est initié et terminé pendant la première phase (P1) et qui est ouvert pendant la deuxième phase (P2).

8. Capteur de champ magnétique selon la revendication 6 ou 7, **caractérisé en ce que** le deuxième amplificateur à transconductance (8) présente une pente plus faible que celle du premier amplificateur à transconductance (7).

9. Capteur de champ magnétique selon l'une quelconque des revendications précédentes, **caractérisé en ce que** la sortie du dispositif d'évaluation (6) est reliée à un circuit de maintien (14) pour la mémorisation et la transmission d'un signal de sortie pendant la deuxième phase (P2).

10. Capteur de champ magnétique selon l'une quelconque des revendications précédentes, **caractérisé en ce que**, en supplément, on prévoit un deuxième élément à effet Hall qui, en ce qui concerne la tension de Hall, est monté de manière antiparallèle et décalé latéralement par rapport au premier élément à effet Hall et est identique à ce dernier.

11. Capteur de champ magnétique selon l'une quelconque des revendications 3 à 10, **caractérisé en ce que** l'on prévoit une source de tension (15) pour produire un signal de tension de polarisation sur la paire de contacts (2, 3) qui est reliée au dispositif d'évaluation (6).

12. Capteur de champ magnétique selon la revendication 11, **caractérisé en ce que** l'on prévoit un organe de commutation (16) qui est relié au circuit de maintien (14) et par l'intermédiaire duquel le signal de tension de polarisation respectif provenant de la source de tension (15) est appliqué à la paire de contacts (2, 3) respective, sur la base d'un signal provenant du circuit de maintien (14), lorsque ce dernier a transmis le signal de sortie.

13. Capteur de champ magnétique selon la revendication 11 ou 12, **caractérisé en ce qu'**une sortie de signal de correction (17) de la source de tension (15) est reliée à une entrée de commande (18) du dispositif d'alimentation en tension (5) pour fournir un signal qui est fonction de la température de l'élément à effet Hall (1).

14. Capteur de champ magnétique selon la revendication 13, **caractérisé en ce que**, dans la source de tension (15), on prévoit une résistance de référence qui est équivalente à l'élément à effet Hall (1).

15. Procédé pour le fonctionnement d'un capteur de champ magnétique selon l'une quelconque des revendications 1 à 14, dans lequel le premier signal de mesure est mémorisé pendant la première phase et est, pendant la deuxième phase, superposé au deuxième signal de mesure dans l'interface (9, 10), procédé dans lequel les composantes du signal utile sont superposées avec la même phase et les composantes du signal de décalage de l'élément à effet Hall (1) et de l'amplificateur d'entrée (7) sont superposées avec des phases opposées.

16. Procédé selon la revendication 15, **caractérisé en ce que** le premier signal de mesure est mémorisé en étant amplifié par un facteur déterminé et est superposé au deuxième signal en étant réduit par le même facteur.
